# EUROPEAN PATENT APPLICATION

(11) **EP 4 794 161 A1**
(43) Date of publication of application: **19.08.2026**
(21) Application number: 25157607.0
(22) Date of filing: 13.02.2025
(51) Int. Cl.: H02J 7/00, G01R 27/26, G01R 27/08, G01R 27/14

(54) **A POWER CONVERTER AND A METHOD FOR CONTROLLING A POWER CONVERTER**

(71) Applicant: Skeleton Technologies GmbH, 04420 Markranstädt (DE)
(72) Inventor: Järveläinen, Tero, 11415 Tallinn (EE)
(74) Representative: Väänänen, Janne Kalervo

(57) **Abstract**

A power converter (101) comprises a first terminal (102) connectable to a capacitive energy storage (106), a converter circuitry (104) for voltage conversion between direct voltage of the first terminal and one or more voltages of a second terminal of the power converter, and a control system (105) for controlling the converter circuitry and discharge circuits of series connected capacitive elements of the capacitive energy storage to control voltage balance between the capacitive elements based on: voltages of the capacitive elements, current of the capacitive energy storage, capacitances of the capacitive elements, and equivalent serial resistances of the capacitive elements. To estimate the capacitances and the equivalent serial resistances, the control circuit controls the converter circuitry to supply identification current via the first terminal and computes the estimates based on the identification current and on changes caused by the identification current in the voltages of the capacitive elements.

## Description

### Field

The invention relates generally to power converters and capacitive energy storages. More particularly, the invention relates to a power converter suitable for being connected to a capacitive energy storage. Furthermore, the invention relates to a method and to a computer program for controlling a power converter connected to a capacitive energy storage.

### Background

Direct "DC" voltage capacitor systems comprise typically strings of series connected capacitive elements each comprising one or more capacitor cells each of which can be, for example, a super-capacitor cell such as a carbon capacitor cell or an electric double layer capacitor "EDLC" cell. A capacitor system of the kind mentioned above can be used, for example, as an energy storage in applications where a power demand of a load can vary significantly over time so that peak power demands can be significantly higher than an average power demand. For example, in a data center, a power demand of a data processing system, e.g. a graphics processing unit "GPU", supplied by an alternating voltage - direct voltage "AC-DC" converter or a direct voltage "DC-DC" converter can vary strongly over time, and thus a capacitive energy storage may be needed to satisfy high peak power demands as well as to react fast enough to changes in the power demand.

For another example, a capacitor system of the kind mentioned above can be used for example in a static reactive power compensator in which the capacitor system is connected to an alternating "AC" voltage network with a network inverter capable of supplying and drawing reactive power to or from the AC voltage network, and thus the static reactive power compensator mimics an unloaded synchronous machine whose excitation current is controlled to control reactive power produced or consumed by the synchronous machine. With modern super capacitors, the capacitance of a capacitor system of a static reactive power compensator can be so high and thereby the energy stored by the capacitor system can be so high that the static reactive power compensator can also be used for supporting active power balance of an AC voltage network for a short period of time.

In applications of the kind mentioned above, there is typically a need to control voltage balance between the series connected capacitive elements. To achieve satisfactory voltage balance control, estimates of equivalent serial resistances "ESR" and capacitances of the series connected capacitive elements are often needed.

### Summary

The following presents a simplified summary to provide basic understanding of some aspects of various embodiments. The summary is not an extensive overview of the invention. It is neither intended to identify key or critical elements of the invention nor to delineate the scope of the invention. The following summary merely presents some concepts in a simplified form as a prelude to a more detailed description of exemplifying and non-limiting embodiments.

In accordance with the invention, there is provided a new power converter which is connectable to a capacitive energy storage. The power converter can be for example a direct-voltage "DC-DC" converter of a DC energy storage or an alternating voltage - direct voltage "AC-DC" converter of e.g. a static reactive power compensator.

A power converter according to the invention comprises:
- a first terminal connectable to a capacitive energy storage,
- a converter circuitry configured to carry out voltage conversion between DC voltage of the first terminal and one or more DC or AC voltages of a second terminal of the power converter, and
- a control system configured to control the converter circuitry and to control discharge circuits of series connected capacitive elements of the capacitive energy storage to control voltage balance between the capacitive elements based on voltages measured from the capacitive elements, current of the capacitive energy storage, estimates of capacitances of the capacitive elements, and estimates of equivalent serial resistances "ESR" of the capacitive elements.

The control system is configured to:
- control the converter circuitry to supply identification current via the first terminal, and
- compute the estimates of the capacitances and the estimates of the equivalent serial resistances based on i) the identification current as the function of time and ii) changes caused by the identification current in the voltages measured from the capacitive elements.

The estimation of the capacitances and the equivalent serial resistances can be carried out for example at a commissioning phase of a system comprising the power converter and the capacitive energy storage, i.e. prior to production use of the system. The estimation can also be carried out during e.g. maintenance and/or other breaks in the production use of the system. Thus, the temporal behavior of the identification current can be selected from the viewpoint of needs related to the estimation of the capacitances and the equivalent serial resistances. Exemplifying ways to compute the estimates of the capacitances and the equivalent serial resistances will be described later in this document. It is however also possible that the control system is configured to form updates for the estimates during the production use of the system based on current and voltages measured during the production use. The estimates of the equivalent serial resistances and the capacitances of the capacitive elements obtained with the identification current are advantageously changed based on the updates only when the updates fulfil a predetermined sanity check requirement.

In accordance with the invention, there is also provided a new method for controlling a power converter of the kind mentioned above and connected to a capacitive energy storage having series connected capacitive elements. The method according to the invention comprises:
- controlling the converter circuitry of the power converter to supply identification current to the capacitive energy storage, and
- computing the estimates of the capacitances and the estimates of the equivalent serial resistances based on i) the identification current as the function of time and ii) changes caused by the identification current in the voltages measured from the capacitive elements.

Various embodiments of the invention can be computer implemented invention "CII" embodiments. Therefore, in accordance with the invention, there is also provided a new computer program for controlling a power converter of the kind mentioned above and connected to a capacitive energy storage having series connected capacitive elements. The computer program according to the invention comprises computer executable instructions for controlling a programmable data processing system of the power converter to:
- control the converter circuitry to supply identification current via the first terminal, and
- compute the estimates of the capacitances and the estimates of the equivalent serial resistances based on i) the identification current as the function of time and ii) changes caused by the identification current in the voltages measured from the capacitive elements.

In accordance with the invention, there is also provided a new computer program product. The computer program product comprises a non-volatile computer readable medium, e.g. an electrically erasable programmable read-only memory "EEPROM", a universal serial bus "USB" memory, or a compact disc "CD", encoded with a computer program according to the invention.

Exemplifying and non-limiting embodiments are described in accompanied dependent claims.

Various exemplifying and non-limiting embodiments both as to constructions and to methods of operation, together with additional objects and advantages thereof, will be best understood from the following description of specific exemplifying and non-limiting embodiments when read in conjunction with the accompanying drawings.

The verbs "to comprise" and "to include" are used in this document as open limitations that neither exclude nor require the existence of unrecited features.

The features recited in dependent claims are mutually freely combinable unless otherwise explicitly stated.

Furthermore, it is to be understood that the use of "a" or "an", i.e. a singular form, throughout this document does not exclude a plurality.

### Brief description of the figures

Exemplifying and non-limiting embodiments and their advantages are explained in greater detail below in the sense of examples and with reference to the accompanying drawings, in which:
Figure 1 illustrates a power converter according to an exemplifying and non-limiting embodiment,
Figure 2 illustrates a power converter according to another exemplifying and non-limiting embodiment, and
Figure 3 shows a flowchart of a method according to an exemplifying and non-limiting embodiment for controlling a power converter connected to a capacitive energy storage.

### Description of the exemplifying embodiments

The specific examples provided in the description given below should not be construed as limiting the scope and/or the applicability of the invention. Lists and groups of examples provided in the description given below are not exhaustive unless otherwise explicitly stated.

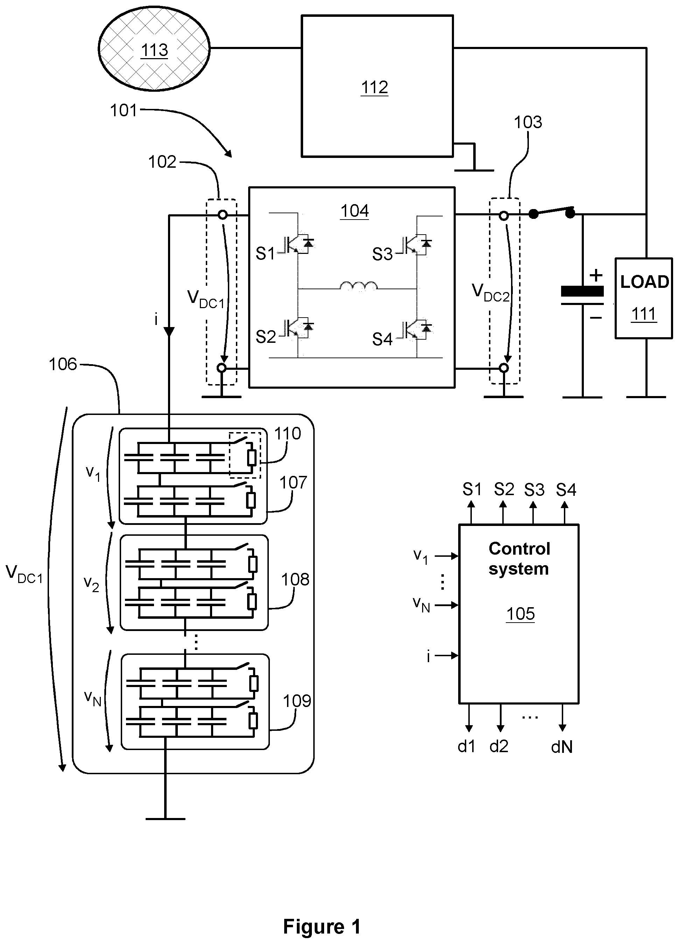

Figure 1 illustrates a power converter 101 according to an exemplifying and non-limiting embodiment. The power converter 101 comprises a first terminal 102 connected to a capacitive energy storage 106. The power converter 101 comprises a converter circuitry 104. In this exemplifying embodiment, the converter circuitry 104 is a direct voltage "DC-DC" converter circuitry configured to carry out voltage conversion between direct voltage V_{DC1} of the first terminal 102 and direct voltage V_{DC2} of a second terminal 103 of the power converter 101. In the exemplifying application shown in figure 1, the power converter 101 is configured to supply energy from the capacitive energy storage 106 to a load 111 during peak power situations of the load 111 and to charge the capacitive energy storage 106 during low power situations of the load 111. Thus, a converter 112 and/or a power supply system 113 can be dimensioned for a smaller peak power. It is to be however noted that the power converter 101 can be used in other applications, too.

The capacitive energy storage 106 comprises series connected capacitive elements. In this exemplifying case, the number of the series connected capacitive elements is N. In figure 1, three of the capacitive elements are denoted with references 107, 108, and 109. Each of the capacitive elements comprises one or more capacitor cells, each of which is connected to a controllable discharge circuit. Each capacitor cell can be, for example, a foil capacitor cell, an electrolytic capacitor cell, a super-capacitor cell such as a carbon capacitor cell or an electric double layer capacitor "EDLC" cell, or a lithium-ion capacitor i.e. hybrid energy storage cell. Each controllable discharge circuit may comprise, for example, a series connection of a dissipation resistor and a switch so that this series connection is in parallel with one or more capacitor cells to be controlled by the controllable discharge circuit. The switch can be e.g. a metal oxide semiconductor field-effect transistor "MOSFET" or some other controllable switch component. In figure 1, one of the controllable discharge circuits is denoted with a reference 110. In exemplifying cases where a capacitive element of the kind mentioned above comprises many capacitor cells, the capacitor cells can be connected in series, in parallel, or in another way to each other. For example, there can be a series connection of a groups of parallel connected capacitor cells or a parallel connection of groups of series connected capacitor cells. In the exemplifying case shown in figure 1, each capacitive element comprises a series connection of groups of parallel connected capacitor cells and each of the groups of parallel connected capacitor cells is provided with one of the above-mentioned controllable discharge circuits.

The power converter 101 comprises a control system 105 that is configured to control the converter circuitry 104. In figure 1, the signals S1, S2, S3, and S4 are control signals for controlling power electronic switches of the converter circuitry 104. The power electronic switches can be e.g. insulated gate bipolar transistors "IGBT", metal oxide field-effect transistors "MOSFET", or some other suitable controllable power electronic components. The control system 105 is also configured to control the above-mentioned controllable discharge circuits of the series connected capacitive elements to control voltage balance between the capacitive elements. In figure 1, the signals d1, d2, ..., dN are control signals for controlling the controllable discharge circuits of the capacitive elements. The voltage balance is controlled based on voltages v₁, v₂, ..., v_{N} measured from the capacitive elements, current i of the capacitive energy storage 106, estimates C₁, C₂, ..., C_{N} of the capacitances of the capacitive elements, and estimates R₁, R₂, ..., R_{N} of the equivalent serial resistances "ESR" of the capacitive elements. Sensors for measuring the above-mentioned voltages and current are not shown in figure 1.

There are many ways to control the above-mentioned controllable discharge circuits to control the voltage balance between the capacitive elements, and the invention is not limited to any specific ways to control the above-mentioned discharge circuits. An exemplifying way is described below.

In a power converter according to an exemplifying and non-limiting embodiment, the control system 105 is configured to compute, for each of the capacitive elements whose voltage value exceeds a predetermined minimum balancing value, a voltage reference according to the following formula: ${V}_{ref_i} = {V}_{set} - \left({C}_{min}/{C}_{i}\right) \left({V}_{set}-\left({v}_{min_C}-i {R}_{i}\right)\right) ,$ where V_{ref_i} is the voltage reference for i^{th} one of the capacitive elements, Cᵢ is an estimate of the capacitance of the i^{th} one of the capacitive elements, Cₘᵢₙ is the smallest one of the estimates of the capacitances of the capacitive elements, v_{min_C} is the voltage of the capacitive element having the smallest capacitance Cₘᵢₙ, i is the current of the capacitive energy storage 106, Rᵢ is an estimate of the equivalent serial resistance "ESR" of the i^{th} one of the capacitive elements, and Vₛₑₜ is a voltage set point such that the imbalance between the capacitive elements is minimized when the voltages of the capacitive elements have the set point value. The control system 105 is configured to activate the controllable discharge circuit of each of the capacitive elements whose voltage exceeds the voltage reference of the capacitive element under consideration.

The control system 105 is configured to carry out an identification run in which the control system 105 controls the converter circuitry 104 to supply identification current i_{ID} via the first terminal 103 to the capacitive energy storage 106, i.e. the current i = i_{ID}. The control system 105 computes the estimates C₁, C₂, ..., C_{N} of the capacitances and the estimates R₁, R₂, ..., R_{N} of the equivalent serial resistances based on i) the identification current i_{ID} as a function of time and ii) changes caused by the identification current in the voltages measured from the capacitive elements. The estimation of the capacitances and the equivalent serial resistances can be carried out for example at a commissioning phase of the system comprising the power converter and the capacitive energy storage, i.e. prior to production use of the system. The estimation can also be carried out during e.g. maintenance and/or other breaks in the production use of the system. Thus, the temporal behavior of the identification current, i.e. the predetermined profile as a function of time, can be selected from the viewpoint of needs related to the estimation of the capacitances and the equivalent serial resistances.

There are many ways to compute the above-mentioned estimates of the capacitances and the equivalent serial resistances, and the invention is not limited to any specific ways to compute the above-mentioned estimates. Exemplifying ways are described below. The below-described exemplifying ways are based on the following model of the iₜₕ one of the capacitive elements: ${v}_{i} \left(t\right) = {v}_{i} \left({t}_{0}\right) + {R}_{i} i \left(t\right) + \frac{1}{{C}_{i}} {\int }_{to}^{t} i \left(t\right) dt ,$ where vᵢ(t) is the voltage of the iₜₕ one of the capacitive elements as a function of time t, v_{i_t0} is the voltage vᵢ at the time moment t₀ that is the beginning of a time period under consideration, Rᵢ is the estimate of the equivalent serial resistance of the iₜₕ one of the capacitive elements, i(t) is the current of the capacitive energy storage 106 as a function of time t, and Cᵢ is the estimate of the capacitance of the iₜₕ one of the capacitive elements.

In a power converter according to an exemplifying and non-limiting embodiment, the control system 105 is configured to control the converter circuitry 104 to supply the identification current i_{ID} so that the identifying current has a predetermined profile as a function of time on at least a part of time when the identification current is supplied.

In a power converter according to an exemplifying and non-limiting embodiment, the control system 105 is configured to control the converter circuitry to supply the identification current i_{ID} so that the identification current has a stepwise change, and to compute the estimates R₁, R₂, ..., R_{N} of the equivalent serial resistances as ratios of resulting stepwise changes of the voltages v₁, v₂, ..., v_{N} measured from the capacitive elements to the stepwise change of the identification current.

In a power converter according to an exemplifying and non-limiting embodiment, the control system 105 is configured to keep the identification current i_{ID} as constant I_{ID_c} and to compute the estimates of the capacitances of the capacitive elements based on i) the constant identification current I_{ID_c} and ii) change rates dv₁/dt, dv₂/dt, ..., dv_{N}/dt of the voltages measured from the capacitive elements. For the iₜₕ one of the capacitive elements: Cᵢ = I_{ID_c} / dvᵢ/dt.

In a power converter according to an exemplifying and non-limiting embodiment, the control system 105 is configured to compute a first electric charge ΔQ₁ supplied to the capacitive energy storage as a time-integral of the identification current i_{ID} over a first time-period at a beginning and at an end of which the identification current has a same value, e.g. zero, and between the beginning and the end of which the identification current deviates from zero. The control system 105 is configured to compute the estimates of the capacitances based on the first electric charge and on changes Δv₁, Δv₂, ..., Δv_{N} of the voltages v₁, v₂, ..., v_{N} occurred on the first time-period. The effects of the equivalent serial resistances are cancelled from the changes Δv₁, Δv₂, ..., Δv_{N} of the voltages because i_{ID} has the same value at the beginning and at the end of the first time-period, and thus for the iₜₕ one of the capacitive elements: Cᵢ = ΔQ₁ / Δvᵢ.

In a power converter according to an exemplifying and non-limiting embodiment, the control system 105 is configured to compute a second electric charge ΔQ₂ supplied to the capacitive energy storage as a time-integral of the identification current i_{ID} over a second time-period at a beginning of which the identification current has a first value and at an end of which the identification current has a second value different from the first value, and to compute the estimates of the equivalent serial resistances according to the following formula: ${R}_{i} = \left({Δv}_{i}-{ΔQ}_{2}/{C}_{i}\right) / \left({i}_{ID_ 2}-{i}_{ID_ 1}\right) ,$ where Rᵢ is the estimate of the equivalent serial resistance of i^{th} one of the capacitive elements, Δvᵢ is a change of the voltage measured from the i^{th} one of the capacitive elements and occurred on the second time-period, ΔQ₂ is the second electric charge, Cᵢ is the estimate of the capacitance of the i^{th} one of the capacitive elements, i_{ID_1} is the identification current at the beginning of the second time-period, and i_{ID_2} is the identification current at the end of the second time-period. In this exemplifying case, the identification current i_{ID} does not need to have a predetermined temporal profile but it suffices that the second time-period is selected so that i_{ID_2} ≠ i_{ID_1}.

In a power converter according to an exemplifying and non-limiting embodiment, the control system 105 is configured to compute electric charges supplied to the capacitive energy storage as time-integrals of the identification current i_{ID} supplied to the capacitive energy storage on time-periods differing from each other, and to minimize, for each of the capacitive elements, a norm of an error vector related to the capacitive element to obtain the estimate of the equivalent serial resistance and the estimate of the capacitance for the capacitive element under consideration. The j^{th} one of elements of the error vector for the i^{th} one of the capacitive elements is: ${e}_{i_j} = {R}_{i} {Δi}_{_j} + \left(1/{C}_{i}\right) {ΔQ}_{_j} - {Δv}_{i_j} ,$ where j is 1, 2, ..., M that is number of the time periods, Rᵢ is the estimate of the equivalent serial resistance of the i^{th} one of the capacitive elements, Cᵢ is the estimate of the capacitance of the i^{th} one of the capacitive elements, Δi_{_j} is a change of the identification current i_{ID} during the j^{th} one of the time-periods, ΔQ_{_j} is the electric charge supplied to the capacitive energy storage during the j^{th} one of the time-periods, and Δv_{i_j} is a change of the voltage measured from the i^{th} one of the capacitive elements and occurred on the j^{th} one of the time-periods. The vector norm to be minimized can be e.g. the 2-norm i.e. the sum of squares of the elements of the error vector, and values for the Rᵢ and Cᵢ which minimize the vector norm can be found e.g. with Kalman filtering or some other suitable optimization method. In this exemplifying case, the identification current i_{ID} does not need to have a predetermined temporal profile but it suffices that the time-periods 1, 2, ..., M are selected so that equations corresponding to the above-presented equation 4 for different ones of these time periods differ from each other.

In a power converter according to an exemplifying and non-limiting embodiment, the control system 105 is configured to compute updates for the estimates of the capacitances and the equivalent serial resistances of the capacitive elements during the production use. The capacitances and/or the equivalent serial resistances can be dependent on temperature and/or other factors, and the updates can be used for following the changes of the capacitances and/or the equivalent serial resistances caused by changes of the temperature and/or other factors. An exemplifying way to compute the updates is described below.

In a power converter according to an exemplifying and non-limiting embodiment, the control system 105 is configured to compute electric charges supplied to the capacitive energy storage as time-integrals of the current i supplied to the capacitive energy storage during the production use of the power converter and the capacitive energy storage on time-periods differing from each other, and to minimize, for each of the capacitive elements, a norm of an error vector related to the capacitive element to obtain an update for the estimate of the equivalent serial resistance and an update for the estimate of the capacitance of the capacitive element under consideration. The j^{th} one of elements of the error vector for the i^{th} one of the capacitive elements is: ${e}_{i_j} = {R}_{i_u} {Δi}_{_j} + \left(1/{C}_{i_u}\right) {ΔQ}_{_j} - {Δv}_{i_j} ,$ where j is 1, 2, ..., M that is number of the time periods, R_{i_u} is the update for the estimate of the equivalent serial resistance of the i^{th} one of the capacitive elements, C_{i_u} is the update for the estimate of the capacitance of the i^{th} one of the capacitive elements, Δi_{_j} is a change of the current i during the j^{th} one of the time-periods, ΔQ_{_j} is the electric charge supplied to the capacitive energy storage during the j^{th} one of the time-periods, and Δv_{i_j} is a change of the voltage measured from the i^{th} one of the capacitive elements and occurred on the j^{th} one of the time-periods. The vector norm to be minimized can be e.g. the 2-norm i.e. the sum of squares of the elements of the error vector, and values for the R_{i_u} and C_{i_u} which minimize the vector norm can be found e.g. with Kalman filtering or some other suitable optimization method.

In a power converter according to an exemplifying and non-limiting embodiment, the control system 105 is configured to compare the updates to a predetermined sanity check requirement and to change the estimates of the equivalent serial resistances and the capacitances of the capacitive elements based on the updates only when the updates fulfil the predetermined sanity check requirement. The sanity check requirement can be, for example, a requirement that a newly computed update may deviate at most by a predetermined percentage, e.g. 5 % from the estimate being in use.

In a power converter according to an exemplifying and non-limiting embodiment, the control system 105 is configured to change the estimates of the equivalent serial resistances and the capacitances according to the following formulas: ${R}_{i_new} = {R}_{i_old} + α \left({R}_{i_u}-{R}_{i_old}\right) ,$ ${C}_{i_new} = {C}_{i_old} + β \left({C}_{i_u}-{C}_{i_old}\right) ,$ where R_{i_new} is a new estimate of the equivalent serial resistance of the i^{th} one of the capacitive elements, R_{i_u} is the update for the estimate of the equivalent serial resistance of the i^{th} one of the capacitive elements, R_{i_old} is an old estimate of the equivalent serial resistance of the i^{th} one of the capacitive elements, α is an update-gain of the resistance estimate e.g. 0.05, C_{i_new} is a new estimate of the capacitance of the i^{th} one of the capacitive elements, C_{i_u} is the update for the estimate of the capacitance of the i^{th} one of the capacitive elements, C_{i_old} is an old estimate of the capacitance of the i^{th} one of the capacitive elements, and β is an update-gain of the capacitance estimate e.g. 0.05.

The system shown in figure 1 may also comprise parallel connected capacitive energy storages each of which can be like the capacitive energy storage 106. The above-presented exemplifying ways to obtain the estimates for the equivalent serial resistances and for the capacitances are applicable if currents supplied to the parallel connected capacitive energy storages are measured or otherwise known.

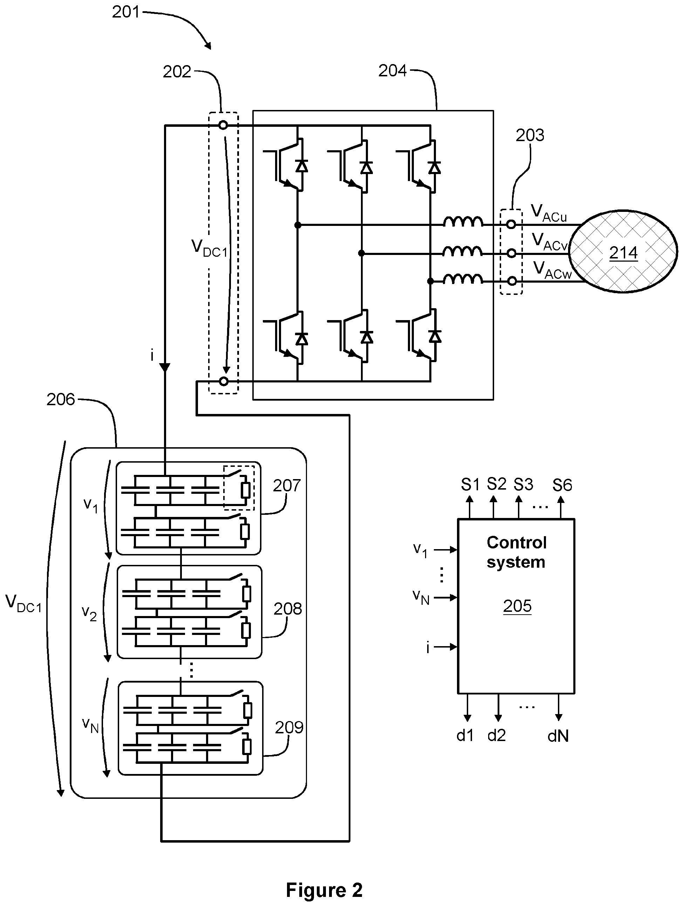

Figure 2 illustrates a power converter 201 according to an exemplifying and non-limiting embodiment. The power converter 201 comprises a first terminal 202 connectable to a capacitive energy storage 206. The power converter 201 comprises a converter circuitry 204. In this exemplifying embodiment, the converter circuitry 204 is an alternating voltage - direct voltage "AC-DC" converter circuitry configured to carry out voltage conversion between direct voltage V_{DC1} of the first terminal 202 and multi-phase alternating "AC" voltage of a second terminal 203 of the power converter. In this exemplifying case, the multi-phase alternating voltage of the second terminal 203 is three-phase alternating voltage having line voltages V_{ACu}, V_{ACv}, and V_{ACw}. In the exemplifying application shown in figure 2, the power converter 201 and the capacitive energy storage 206 constitute a static reactive power compensator that is connected to an alternating voltage "AC" grid 214. The capacitive energy storage 206 comprises series connected capacitive elements. In this exemplifying case, the number of the series connected capacitive elements is N. In figure 2, three of the capacitive elements are denoted with references 207, 208, and 209. Each of the capacitive elements comprises one or more capacitor cells, each of which is connected to a controllable discharge circuit. Each capacitor cell can be, for example, a foil capacitor cell, an electrolytic capacitor cell, or a super-capacitor cell such as a carbon capacitor cell or an electric double layer capacitor "EDLC" cell. With modern super capacitors, the capacitance of the capacitive energy storage 206 can be so high and thereby the energy stored by the capacitive energy storage 206 can be so high that the static reactive power compensator can also be used for supporting active power balance of the AC grid 214 for a short period of time.

The power converter 201 comprises a control system 205 that is configured to control the converter circuitry 204. In figure 2, the signals S1, S2, S3, ..., S6 are control signals for controlling power electronic switches of the converter circuitry 204. The power electronic switches can be e.g. insulated gate bipolar transistors "IGBT", metal oxide field-effect transistors "MOSFET", or some other suitable controllable power electronic components. The control system 205 is also configured to control the above-mentioned controllable discharge circuits of the series connected capacitive elements to control voltage balance between the capacitive elements. In figure 2, the signals d1, d2, ..., dN are control signals for controlling the controllable discharge circuits of the capacitive elements. The voltage balance is controlled based on voltages v₁, v₂, ..., v_{N} measured from the capacitive elements, current i of the capacitive energy storage 206, estimates C₁, C₂, ..., C_{N} of the capacitances of the capacitive elements, and estimates R₁, R₂, ..., R_{N} of the equivalent serial resistances "ESR" of the capacitive elements. Sensors for measuring the above-mentioned voltages and current are not shown in figure 2.

The above-mentioned controllable discharge circuits can be controlled to control the voltage balance between the capacitive elements, for example, in the exemplifying way described above with reference to figure 1. The above-mentioned estimates C₁, C₂, ..., C_{N} of the capacitances as well as the estimates R₁, R₂, ..., R_{N} of the equivalent serial resistances can be obtained, for example, in the exemplifying ways described above with reference to figure 1.

The system shown in figure 2 may also comprise parallel connected capacitive energy storages each of which can be like the capacitive energy storage 206. The above-mentioned exemplifying ways to obtain the estimates for the equivalent serial resistances and for the capacitances are applicable if currents supplied to the parallel connected capacitive energy storages are measured or otherwise known.

Each of the control systems 105 and 205 shown in figure 1 and 2 comprises driver circuits configured to drive the respective controllable power electronic switches, e.g. IGBTs or MOSFETs Furthermore, each of the control systems 105 and 205 comprises a processing system that may comprise one or more analogue circuits, one or more digital processing circuits, or a combination thereof. Each digital processing circuit can be a programmable processor circuit provided with appropriate software, a dedicated hardware processor such as for example an application specific integrated circuit "ASIC", or a configurable hardware processor such as for example a field programmable gate array "FPGA". Furthermore, the processing system may comprise one or more memory circuits each of which can be for example a Random-Access Memory "RAM" circuit and/or a nonvolatile memory circuit such as e.g. an electrically erasable programmable read-only memory "EEPROM" circuit.

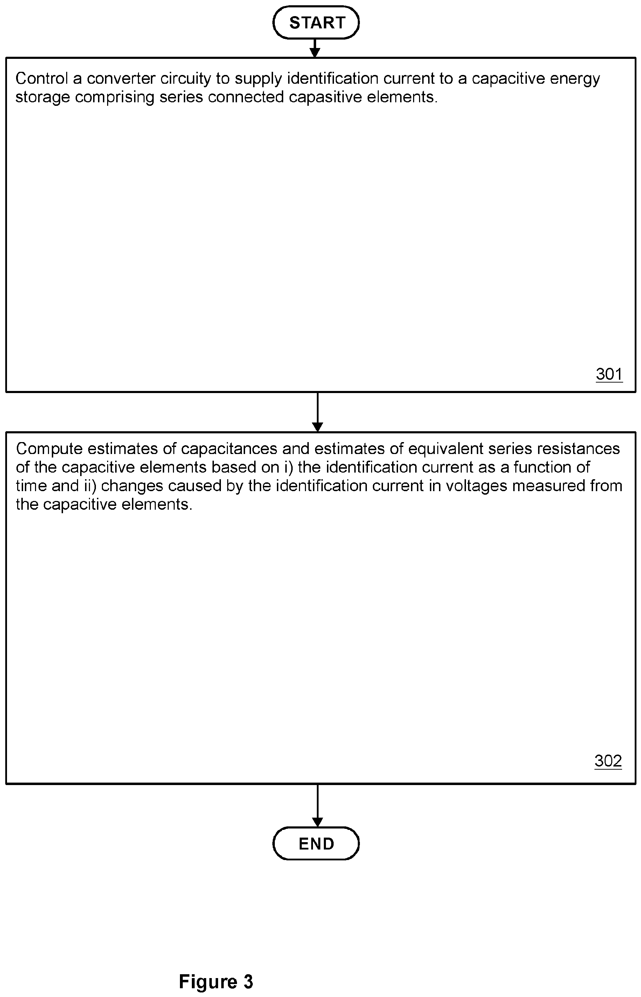

Figure 3 shows a flowchart of a method according to an exemplifying and non-limiting embodiment for controlling a power converter which is connected to a capacitive energy storage and which comprises:
- a first terminal connected to the capacitive energy storage,
- a converter circuity configured to carry out voltage conversion between direct voltage of the first terminal and one or more voltages of a second terminal of the power converter, and
- a control system configured to control the converter circuity and to control discharge circuits of series connected capacitive elements of the capacitive energy storage to control voltage balance between the capacitive elements based on voltages measured from the capacitive elements, current of the capacitive energy storage, estimates of capacitances of the capacitive elements, and estimates of equivalent series resistances of the capacitive elements.

The method comprises the following actions:
- action 301: controlling the converter circuity to supply identification current via the first terminal to the capacitive energy storage, and
- action 301: computing the estimates of the capacitances and the estimates of the equivalent series resistances based on i) the identification current as the function of time and ii) changes caused by the identification current in the voltages measured from the capacitive elements.

A method according to an exemplifying and non-limiting embodiment comprises controlling the converter circuitry to supply the identification current so that the identifying current has a predetermined profile as the function of time on at least a part of time when the identification current is supplied.

A method according to an exemplifying and non-limiting embodiment comprises computing a first electric charge supplied to the capacitive energy storage as a time-integral of the identification current over a first time-period at a beginning and at an end of which the identification current has a same value and between the beginning and the end of which the identification current deviates from zero, and computing the estimates of the capacitances based on the electric charge and on changes occurred on the first time-period in the voltages of the capacitive elements..

A method according to an exemplifying and non-limiting embodiment comprises keeping the identification current as constant and computing the estimates of the capacitances of the capacitive elements based on i) the constant identification current and ii) change rates of the voltages measured from the capacitive elements.

A method according to an exemplifying and non-limiting embodiment comprises controlling the converter circuitry to supply the identification current so that the identification current has a stepwise change, and computing the estimates of the equivalent serial resistances as ratios of resulting stepwise changes in the voltages measured from the capacitive elements to the stepwise change of the identification current.

A method according to an exemplifying and non-limiting embodiment comprises computing a second electric charge supplied to the capacitive energy storage as a time-integral of the identification current over a second time-period at a beginning of which the identification current has a first value and at an end of which the identification current has a second value different from the first value, and computing the estimates of the equivalent serial resistances according to the following formula: ${R}_{i} = \left({Δv}_{i}-{ΔQ}_{2}/{C}_{i}\right) / \left({i}_{ID_ 2}-{i}_{ID_ 1}\right) ,$ where Rᵢ is the estimate of the equivalent serial resistance of i^{th} one of the capacitive elements, Δvᵢ is a change of the voltage measured from the i^{th} one of the capacitive elements and occurred on the second time-period, ΔQ₂ is the second electric charge, Cᵢ is the estimate of the capacitance of the i^{th} one of the capacitive elements, i_{ID_1} is the identification current at the beginning of the second time-period, and i_{ID_2} is the identification current at the end of the second time-period.

A method according to an exemplifying and non-limiting embodiment comprises computing electric charges supplied to the capacitive energy storage as time-integrals of the identification current supplied to the capacitive energy storage on time-periods differing from each other, and to minimize, for each of the capacitive elements, a norm of an error vector related to the capacitive element to obtain the estimate of the equivalent serial resistance and the estimate of the capacitance of the capacitive element. The j^{th} one of elements of the error vector for i^{th} one of the capacitive elements is: ${e}_{i_j} = {R}_{i} {Δi}_{_j} + \left(1/{C}_{i}\right) {ΔQ}_{_j} - {Δv}_{i_j} ,$ where j is 1, 2, ..., M that is number of the time-periods, Rᵢ is the estimate of the equivalent serial resistance of the i^{th} one of the capacitive elements, Cᵢ is the estimate of the capacitance of the i^{th} one of the capacitive elements, Δi_{_j} is a change of the identification current during a j^{th} one of the time-periods, ΔQ_{_j} is the electric charge supplied to the capacitive energy storage during the j^{th} one of the time-periods, and Δv_{i_j} is a change of the voltage measured from the i^{th} one of the capacitive elements and occurred on the j^{th} one of the time-periods.

A method according to an exemplifying and non-limiting embodiment comprises computing updates for the estimates of the capacitances and the equivalent serial resistances of the capacitive elements during the production use of the power converter and the capacitive energy storage. An exemplifying method to compute the updates is presented below:
A method according to an exemplifying and non-limiting embodiment comprises computing electric charges supplied to the capacitive energy storage as time-integrals of current supplied to the capacitive energy storage during production use on time-periods differing from each other, and minimizing, for each of the capacitive elements, a norm of an error vector related to the capacitive element to obtain an update for the estimate of the equivalent serial resistance and an update for the estimate of the capacitance of the capacitive element. The j^{th} one of the elements of the error vector for i^{th} one of the capacitive elements is: ${e}_{i_j} = {R}_{i_u} {Δi}_{_j} + \left(1/{C}_{i_u}\right) {ΔQ}_{_j} - {Δv}_{i_j} ,$ where j is 1, 2, ..., M that is number of the time-periods, R_{i_u} is the update for the estimate of the equivalent serial resistance of the i^{th} one of the capacitive elements, C_{i_u} is the update for the estimate of the capacitance of the i^{th} one of the capacitive elements, Δi_{_j} is a change of the current during a j^{th} one of the time-periods, Q_{_j} is the electric charge supplied to the capacitive energy storage during the j^{th} one of the time-periods, and Δv_{i_j} is a change of the voltage measured from the i^{th} one of the capacitive elements and occurred on the j^{th} one of the time-periods.

A method according to an exemplifying and non-limiting embodiment comprises comparing the updates to a predetermined sanity check requirement and changing the estimates of the equivalent serial resistances and the capacitances of the capacitive elements based on the updates only when the updates fulfil the predetermined sanity check requirement.

A method according to an exemplifying and non-limiting embodiment comprises changing the estimates of the equivalent serial resistances and the capacitances according to the following formulas: ${R}_{i_new} = {R}_{i_old} + α \left({R}_{i_u}-{R}_{i_old}\right) ,$ ${C}_{i_new} = {C}_{i_old} + β \left({C}_{i_u}-{C}_{i_old}\right) ,$ where R_{i_new} is a new estimate of the equivalent serial resistance of the i^{th} one of the capacitive elements, R_{i_u} is the update for estimate of the equivalent serial resistance of the i^{th} one of the capacitive elements, R_{i_old} is an old estimate of the equivalent serial resistance of the i^{th} one of the capacitive elements, α is an update-gain of the resistance estimate e.g. 0.05, C_{i_new} is a new estimate of the capacitance of the i^{th} one of the capacitive elements, C_{i_u} is the update for estimate of the capacitance of the i^{th} one of the capacitive elements, C_{i_old} is an old estimate of the capacitance of the i^{th} one of the capacitive elements, β is an update-gain of the capacitance estimate e.g. 0.05.

In a method according to an exemplifying and non-limiting embodiment, the one or more voltages of the second terminal of the power converter is direct voltage, and the converter circuitry is a direct voltage converter circuitry configured to carry out voltage conversion between the direct voltage of the first terminal of the power converter and the direct voltage of the second terminal of the power converter.

In a method according to another exemplifying and non-limiting embodiment, the one or more voltages of the second terminal of the power converter constitute a multi-phase alternating voltage, and the converter circuitry is an alternating voltage - direct voltage converter circuitry configured to carry out voltage conversion between the direct voltage of the first terminal of the power converter and the multi-phase alternating voltage of the second terminal of the power converter.

A computer program according to an exemplifying and non-limiting embodiment for controlling a power converter connected to a capacitive energy storage comprises computer executable instructions for controlling a programmable data processing system to carry out actions related to a method according to any of the above-described exemplifying and non-limiting embodiments.

A computer program according to an exemplifying and non-limiting embodiment comprises software modules for controlling a power converter of the kind described above. The software modules comprise computer executable instructions for controlling a programmable data processing system of the power converter to:
- control the converter circuity of the power converter to supply identification current to the capacitive energy storage, and
- compute the estimates of the capacitances and the estimates of the equivalent series resistances based on i) the identification current as a function of time and ii) changes caused by the identification current in the voltages measured from the series connected capacitive elements of the capacitive energy storage.

The software modules can be, for example, subroutines or functions implemented with programming tools suitable for the programmable data processing system.

A computer program product according to an exemplifying and non-limiting embodiment comprises a computer readable medium, e.g. an EEPROM, a USB memory, or a compact disc "CD", encoded with a computer program according to an exemplifying embodiment of the invention.

A signal according to an exemplifying and non-limiting embodiment is encoded to carry information defining a computer program according to an exemplifying embodiment of the invention.

A non-volatile computer readable medium, e.g. an EEPROM, a USB memory, or a CD ROM, according to an exemplifying and non-limiting embodiment is encoded with a computer program according to an exemplifying embodiment of the invention.

The specific examples provided in the description given above should not be construed as limiting the applicability and/or the interpretation of the invention. Lists and groups of examples provided in the description given above are not exhaustive unless otherwise explicitly stated.

## Claims

1. A power converter (101, 201) comprising:
- a first terminal (102, 202) connectable to a capacitive energy storage,
- a converter circuitry (104, 204) configured to carry out voltage conversion between direct voltage (V_{DC1}) of the first terminal and one or more voltages (V_{DC2}, V_{ACu}, V_{ACv}, V_{ACw}) of a second terminal (103, 203) of the power converter, and
- a control system (105, 205) configured to control the converter circuitry and to control discharge circuits of series connected capacitive elements of the capacitive energy storage to control voltage balance between the capacitive elements based on voltages (v₁, v₂, ..., v_{N}) measured from the capacitive elements, current (i) of the capacitive energy storage, estimates (C₁, C₂, ... , C_{N}) of capacitances of the capacitive elements, and estimates (R₁, R₂, ..., R_{N}) of equivalent serial resistances of the capacitive elements,
**characterized in that** the control system is configured to:
- control the converter circuitry to supply identification current (i_{ID}) via the first terminal, and
- compute the estimates of the capacitances and the estimates of the equivalent serial resistances based on i) the identification current as the function of time and ii) changes caused by the identification current in the voltages measured from the capacitive elements.

2. A power converter according to claim 1, wherein the control system is configured to control the converter circuitry to supply the identification current so that the identifying current has a predetermined profile as the function of time on at least a part of time when the identification current is supplied.

3. A power converter according to claim 2, wherein the control system is configured to compute a first electric charge (ΔQ₁) supplied to the capacitive energy storage as a time-integral of the identification current (i_{ID}) over a first time-period at a beginning and at an end of which the identification current has a same value and between the beginning and the end of which the identification current deviates from zero, and to compute the estimates of the capacitances based on the electric charge and on changes (Δv₁, Δv₂, ..., Δv_{N}) of the voltages occurred on the first time-period.

4. A power converter according to claim 2 or 3, wherein the control system is configured to keep the identification current (i_{ID}) as constant (I_{ID_c}) and to compute the estimates of the capacitances of the capacitive elements based on i) the constant identification current (I_{ID_c}) and ii) change rates of the voltages measured from the capacitive elements.

5. A power converter according to any one of claims 2-4, wherein the control system is configured to control the converter circuitry to supply the identification current (i_{ID}) so that the identification current has a stepwise change, and to compute the estimates of the equivalent serial resistances as ratios of resulting stepwise changes of the voltages measured from the capacitive elements to the stepwise change of the identification current.

6. A power converter according to any one of claims 1-5, wherein the control system is configured to compute a second electric charge (ΔQ₂) supplied to the capacitive energy storage as a time-integral of the identification current (i_{ID}) over a second time-period at a beginning of which the identification current has a first value and at an end of which the identification current has a second value different from the first value, and to compute the estimates of the equivalent serial resistances according to a following formula: ${R}_{i} = \left({Δv}_{i}-{ΔQ}_{2}/{C}_{i}\right) / \left({i}_{ID_ 2}-{i}_{ID_ 1}\right) ,$ where Rᵢ is the estimate of the equivalent serial resistance of i^{th} one of the capacitive elements, Δvᵢ is a change of the voltage measured from the i^{th} one of the capacitive elements and occurred on the second time-period, ΔQ₂ is the second electric charge, Cᵢ is the estimate of the capacitance of the i^{th} one of the capacitive elements, i_{ID_1} is the identification current at the beginning of the second time-period, and i_{ID_2} is the identification current at the end of the second time-period.

7. A power converter according to any one of claims 1-6, wherein the control system is configured to compute electric charges (ΔQ) supplied to the capacitive energy storage as time-integrals of the identification current supplied to the capacitive energy storage on time-periods differing from each other, and to minimize, for each of the capacitive elements, a norm of an error vector related to the capacitive element to obtain the estimate of the equivalent serial resistance and the estimate of the capacitance of the capacitive element, a j^{th} one of elements of the error vector for i^{th} one of the capacitive elements being: ${e}_{i_j} = {R}_{i} {Δi}_{_j} + \left(1/{C}_{i}\right) {ΔQ}_{_j} - {Δv}_{i_j} ,$ where j is 1, 2, ..., M that is number of the time-periods, Rᵢ is the estimate of the equivalent serial resistance of the i^{th} one of the capacitive elements, Cᵢ is the estimate of the capacitance of the i^{th} one of the capacitive elements, Δi_{_j} is a change of the identification current during a j^{th} one of the time-periods, ΔQ_{_j} is the electric charge supplied to the capacitive energy storage during the j^{th} one of the time-periods, and Δv_{i_j} is a change of the voltage measured from the i^{th} one of the capacitive elements and occurred on the j^{th} one of the time-periods.

8. A power converter according to any one of claims 1-7, wherein the control system is configured to compute electric charges (ΔQ) supplied to the capacitive energy storage as time-integrals of current supplied to the capacitive energy storage during production use of the power converter and the capacitive energy storage on time-periods differing from each other, and to minimize, for each of the capacitive elements, a norm of an error vector related to the capacitive element to obtain an update for the estimate of the equivalent serial resistance and an update for the estimate of the capacitance of the capacitive element, a j^{th} one of elements of the error vector for i^{th} one of the capacitive elements being: ${e}_{i_j} = {R}_{i_u} {Δi}_{_j} + \left(1/{C}_{i_u}\right) {ΔQ}_{_j} - {Δv}_{i_j} ,$ where j is 1, 2, ..., M that is number of the time-periods, R_{i_u} is the update for the estimate of the equivalent serial resistance of the i^{th} one of the capacitive elements, C_{i_u} is the update for the estimate of the capacitance of the i^{th} one of the capacitive elements, Δi_{_j} is a change of the current during a j^{th} one of the time-periods, ΔQ_{_j} is the electric charge supplied to the capacitive energy storage during the j^{th} one of the time-periods, and Δv_{i_j} is a change of the voltage measured from the i^{th} one of the capacitive elements and occurred on the j^{th} one of the time-periods.

9. A power converter according to claim 8, wherein the control system is configured to compare the updates to a predetermined sanity check requirement and to change the estimates of the equivalent serial resistances and the capacitances of the capacitive elements based on the updates only when the updates fulfil the predetermined sanity check requirement.

10. A power converter according to claim 8 or 9, wherein the control system is configured to change the estimates of the equivalent serial resistances and the estimates of the capacitances according to the following formulas: ${R}_{i_new} = {R}_{i_old} + α \left({R}_{i_u}-{R}_{i_old}\right) ,$ ${C}_{i_new} = {C}_{i_old} + β \left({C}_{i_u}-{C}_{i_old}\right) ,$ where R_{i_new} is a new estimate of the equivalent serial resistance of the i^{th} one of the capacitive elements, R_{i_u} is the update for the estimate of the equivalent serial resistance of the i^{th} one of the capacitive elements, R_{i_old} is an old estimate of the equivalent serial resistance of the i^{th} one of the capacitive elements, α is an update-gain for the estimates of the equivalent serial resistances, C_{i_new} is a new estimate of the capacitance of the i^{th} one of the capacitive elements, C_{i_u} is the update for the estimate of the capacitance of the i^{th} one of the capacitive elements, C_{i_old} is an old estimate of the capacitance of the i^{th} one of the capacitive elements, and β is an update-gain for the estimates of the capacitances.

11. A power converter according to any one of claims 1-10, wherein the one or more voltages of the second terminal of the power converter is direct voltage (V_{DC2}), and the converter circuitry (104) is a direct voltage converter circuitry configured to carry out voltage conversion between the direct voltage (V_{DC1}) of the first terminal of the power converter and the direct voltage of the second terminal of the power converter.

12. A power converter according to any one of claims 1-10, wherein the one or more voltages of the second terminal of the power converter constitute a multi-phase alternating voltage (V_{ACu}, V_{ACv}, V_{ACw}), and the converter circuitry (204) is an alternating voltage - direct voltage converter circuitry configured to carry out voltage conversion between the direct voltage (V_{DC1}) of the first terminal of the power converter and the multi-phase alternating voltage of the second terminal of the power converter.

13. A method for controlling a power converter (101, 201) that comprises:
- a first terminal (102, 202) connected to a capacitive energy storage (106, 206),
- a converter circuitry (104, 204) configured to carry out voltage conversion between direct voltage (V_{DC1}) of the first terminal and one or more voltages (V_{DC2}, V_{ACu}, V_{ACv}, V_{ACw}) of a second terminal (103, 203) of the power converter, and
- a control system (105, 205) configured to control the converter circuitry and to control discharge circuits (110) of series connected capacitive elements (107-109, 207-209) of the capacitive energy storage to control voltage balance between the capacitive elements based on voltages (v₁, v₂, ..., v_{N}) measured from the capacitive elements, current (i) of the capacitive energy storage, estimates (C₁, C₂, ..., C_{N}) of capacitances of the capacitive elements, and estimates (R₁, R₂, ..., R_{N}) of equivalent serial resistances of the capacitive elements,
**characterized in that** the method comprises:
- controlling (301) the converter circuitry to supply identification current (i_{ID}) via the first terminal to the capacitive energy storage, and
- computing (302) the estimates of the capacitances and the estimates of the equivalent serial resistances based on i) the identification current as the function of time and ii) changes caused by the identification current in the voltages measured from the capacitive elements.

14. A computer program for controlling a power converter (101, 201) that comprises:
- a first terminal (102, 202) connected to a capacitive energy storage (106, 206),
- a converter circuitry (104, 204) configured to carry out voltage conversion between direct voltage (V_{DC1}) of the first terminal and one or more voltages (V_{DC2}, V_{ACu}, V_{ACv}, V_{ACw}) of a second terminal (103, 203) of the power converter, and
- a control system (105, 205) configured to control the converter circuitry and to control discharge circuits (110) of series connected capacitive elements (107-109, 207-209) of the capacitive energy storage to control voltage balance between the capacitive elements based on voltages (v₁, v₂, ..., v_{N}) measured from the capacitive elements, current (i) of the capacitive energy storage, estimates (C₁, C₂, ..., C_{N}) of capacitances of the capacitive elements, and estimates (R₁, R₂, ..., R_{N}) of equivalent serial resistances of the capacitive elements,
**characterized in that** the computer program comprises computer executable instructions for controlling a programmable data processing system of the control system to:
- control the converter circuitry to supply identification current (i_{ID}) via the first terminal, and
- compute the estimates of the capacitances and the estimates of the equivalent serial resistances based on i) the identification current as the function of time and ii) changes caused by the identification current in the voltages measured from the capacitive elements.

15. A non-volatile computer readable medium encoded with a computer program according to claim 14.
